# EUROPEAN PATENT APPLICATION

(11) **EP 1 993 334 A2**
(43) Date of publication of application: **19.11.2008**
(21) Application number: 08251736.8
(22) Date of filing: 16.05.2008
(51) Int. Cl.: H05K 1/02

(54) **Lighting device**

(30) Priority: 16.05.2007 JP 2007130490
(71) Applicant: NEC Lighting, Ltd., Shinagawa-ku Tokyo 141-0032 (JP)
(72) Inventor: Okimura, Katsuyuki c/o NEC Lighting Ltd., Tokyo 141-0032 (JP)
(74) Representative: Reeve, Nicholas Edward

(57) **Abstract**

A lighting device of the present invention includes light emitting unit 20 having a light emitting element installed on a board, and body 11 having light emitting unit 20 mounted thereon. Body 11 has graphite having anisotropic heat conductivity, and the graphite has inner wall 11c in thermal contact with light emitting unit 20. The anisotropy of the graphite has direction Z having a first heat conductivity and direction X₁ having a second heat conductivity that is higher than the first heat conductivity. Inner wall 11 c of the graphite to which heat generated from light emitting unit 20 is transferred is formed to intersect with direction X₁.

## Description

### BACKGROUND OF THE INVENTION

The present invention relates to a lighting device including an LED chip as a light emitting element.

When manufacturing a lighting device and a backlight unit using a solid light emitting device, sufficient heat dissipation is necessary so as not to lower the luminous efficiency of the solid light emitting device.

Generally, a solid light emitting device is implemented on a metal core printed circuit board to be used as a light emitting unit. The light emitting unit is fixed on a metal body of a lighting device by using a screw screwing. That is, for a heat dissipation structure, the metal body of a lighting device is generally used as a radiator.

In the heat dissipation structure configured as described above, when more heat dissipation is required, a method of enlarging a surface area of the metal body or increasing a thickness thereof can be considered.

The body of a lighting device, generally, is formed of metal such as iron (heat conductivity: 80.3 [Wm⁻¹K⁻¹]) or aluminum (heat conductivity: 237 [Wm⁻¹K⁻¹]) having a high heat conductivity. However, the increased thickness of the body of a lighting device causes an increase in weight, resulting in a negative effect on transportation. Further, such increased weight may exceed an allowable weight value of a rectangular ceiling rosette, 5 [Kg], that is directly installed on a ceiling when the lighting device is an appliance for household use.

Then, to improve characteristics of heat dissipation without an increase in weight, a method of using graphite as the material of a body of a lighting device can be considered is conceivable. For example, when a composite material of graphite and aluminum, GC320 (from GELTEC Co., Ltd.: density: 2.17 [g/cm³]) is used, the weight can be reduced to about a quarter of that in the case of using iron (density: 7.9 [g/cm³]) having the same volume.

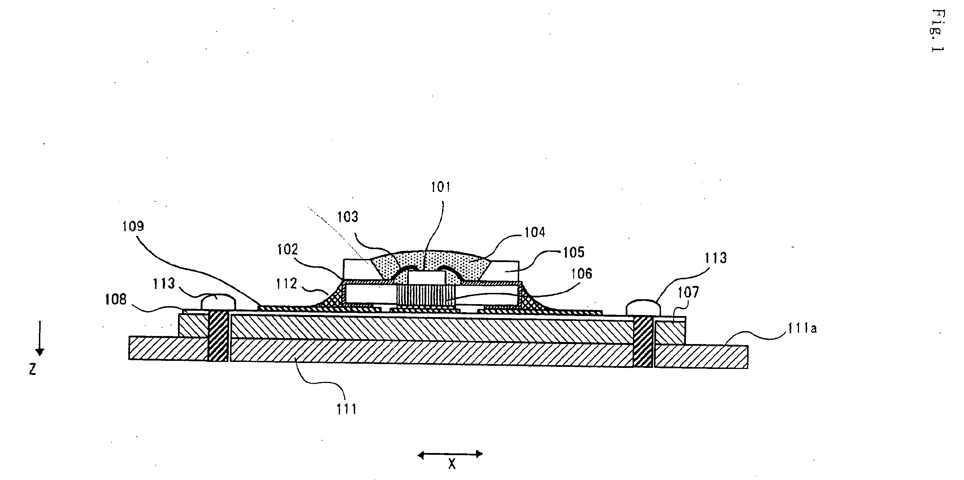

FIG. 1 is a schematic, side cross-section view of one example of a lighting device using graphite, related to the present invention.

LED chip 101 is disposed in an opening formed in molded resin 105, and encapsulated with encapsulating resin 104. Further, LED chip 101 is placed on heat sink 106 so that its underside comes into contact with heat sink 106. LED chip 101 and lead frame electrode 102 are electrically connected to each other with bonding wire 103.

Lead frame electrode 102 and heat sink 106 are provided on pattern wiring 109. Lead frame electrode 102 is fixed to pattern wiring 109 with solder 112. Heat sink 106 is also fixed to pattern wiring 109 with, for example, a thermally conductive adhesive. Pattern wiring 109 is formed on insulating layer 108 of metal core printed circuit board 107.

Metal core printed circuit board 107 is fixed on main surface 111a of body 111 with screw 113. Body 111 is made of graphite. That is, the lighting device shown in FIG. 1 has a configuration in which the graphite is entirely mounted on the underside of metal core printed circuit board 107.

Heat generated by LED chip 101 is transferred to metal core printed circuit board 107 through pattern wiring 109 and insulating layer 108. The heat transferred to metal core printed circuit board 107 is further transferred to main surface 111 a of body 111. The heat transferred to body 111 is conducted and diffused in body 111 in a direction toward the surface, and finally dissipated from main surface 111a of body 111 to the atmosphere.

Further, a light emitting module configured similarly to the configuration described above is disclosed in Japanese Patent Laid-Open No. 2003-324214. Light emitting module 49 shown in FIG. 26 in Japanese Patent Laid-Open No. 2003-324214 has radiator plate 50 composed of a graphite sheet or the like entirely bonded onto the underside of insulating board 32.

By the way, graphite has anisotropic heat conductivity. For example, GC320 has the heat conductivity in a predetermined direction of 320 [Wm⁻¹K⁻¹], and in contrast, has the heat conductivity of 172 [Wm⁻¹K⁻¹] in a direction perpendicular to this predetermined direction.

Then, when graphite is used as a radiator plate, it is necessary to take into consideration the anisotropy of the heat conductivity.

Here, referring to the lighting device in FIG. 1, heat dissipation through graphite will be studied.

First, a case will be studied where body 111 is formed of graphite and where the direction in which there is higher heat conductivity is direction X in FIG. 1. That is, a case will be studied where the direction in which there is higher heat conductivity is approximately perpendicular to a direction in which heat generated by LED chip 101 is transferred.

In this case, the heat generated by LED chip 101 is well conducted in direction X of body 111. On the other hand, the heat is not easily conducted in direction Z of body 111. As the result, only a part of the graphite (body 111) near the surface on the side of LED chip 101 contributes to heat conduction, and the entire thickness of body 111 cannot be effectively used. That is, in this configuration, if the thickness of the graphite is increased in order to conduct a lot of heat in direction X, a satisfactory effect cannot be provided.

In contrast to this, a case will be studied where body 111 is formed of graphite and where the direction in which there is higher heat conductivity is direction C in FIG. 1. That is, a case will be studied where the direction in which there is higher heat conductivity is the same direction in which heat generated by LED chip 101 is transferred. In this case, the heat generated by LED chip 101 is well conducted in direction Z of body 111. On the other hand, the heat is not easily conducted in direction X of body 111. As a result, the heat is not easily conducted to the entire surface of the graphite (body 111). That is, in this configuration, the entire surface of main surface 111a cannot be effectively used as a heat dissipation surface.

As described above, in the lighting device of the configuration related to the present invention, it has been difficult to satisfactorily utilize the heat diffusion characteristics of graphite.

We have therefore appreciated that it would be desirable to provide a lighting device capable of satisfactorily utilizing heat diffusion characteristics of a heat conduction member having anisotropic heat conduction characteristics.

### SUMMARY OF THE INVENTION

A lighting device according to a preferred embodiment of the invention, includes: a light emitting unit having a light emitting element installed on a board; and a body having the light emitting unit mounted thereon, in which the body has a heat conduction member having anisotropic heat conductivity, the heat conduction member has a heat transfer surface in thermal contact with the light emitting unit, the anisotropy includes a first and second direction having in which heat conductivity in the second direction is higher than heat conductivity in the first direction.

According to the present invention, heat generated from the light emitting unit is transferred to the heat conduction member from the heat transfer surface in the direction intersecting with the second direction having the higher heat conductivity. That is, in the present invention, because the heat is transferred in the direction having the higher heat conductivity, the heat can be transferred in the second direction while suppressing an effect of the first heat conductivity lower than the second heat conductivity. Consequently, the present invention can sufficiently utilize heat diffusion characteristics of the heat conduction member having an anisotropic heat conductivity.

The above and other features, and advantages of the present invention will become apparent from the following description with reference to the accompanying drawings, which illustrate examples of the present invention.

### BRIEF DESCRIPTION OF THE DRAWINGS:

FIG. 1 is a schematic, side cross-section view of a lighting device related to the present invention;
FIG. 2 is a schematic, side cross-section view of a lighting device of a first exemplary embodiment according to the present invention; and
FIG. 3 is a schematic, side cross-section view of a lighting device of a second exemplary embodiment according to the present invention.

### DETAILED DESCRIPTION OF THE EXEMPLARY EMBODIMENT(S)

Exemplary embodiments of the present invention will be hereinafter described with reference to the accompanying drawings.

### (First Exemplary Embodiment)

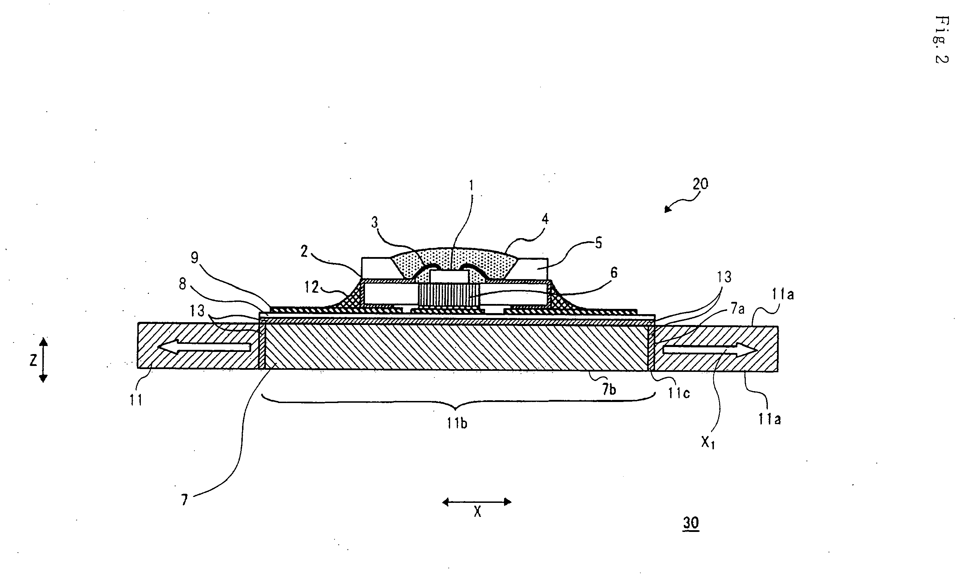

FIG. 2 is a schematic, side cross-section view of a lighting device of the present exemplary embodiment.

Lighting device 30 of the present invention includes light emitting unit 20 and body 11. Light emitting unit 20 has LED chip 1. This light emitting unit 20 placed on metal core printed circuit board 7 is mounted on body 11. Body 11 uses graphite. The graphite has anisotropic heat conductivity. The anisotropy has a first direction having a first heat conductivity and a second direction having a second heat conductivity higher than the first heat conductivity. The thickness direction of body 11 of the present exemplary embodiment is oriented to the first direction (direction Z). Also, in body 11 of the present exemplary embodiment, a direction parallel to main surface 11a that acts as a heat dissipation surface is set to the second direction (direction X, direction X₁ in which heat conductivity is high). That is, body 11 of the present exemplary embodiment uses graphite so as to enhance the heat diffusion characteristics in the surface direction.

LED chip 1 which is a light emitting element is placed in an opening formed in molded resin 5, and encapsulated with encapsulating resin 4. LED chip 1 and lead frame electrode 2 are electrically connected to each other with bonding wire 3. Lead frame electrode 2 also has an opening formed therein. LED chip 1 is placed in the opening of lead frame electrode 2. Further, heat sink 6 is also placed in the opening of lead frame electrode 2. That is, LED chip 1 is provided on heat sink 6. Consequently, most of the heat generated by LED chip 1 is transferred to heat sink 6 from the underside of LED chip 1 rather than from the side of encapsulating resin 4. Materials used for heat sink 6 include alloy of Cu, and Cu and Zr, alloy of Cu and Fe, materials of these alloys to which another element is added, aluminum, and the like. Further, to lower the heat transfer resistance between LED chip 1 and heat sink 6, for example, it is preferable that they be joined to each other with solder of Au-20Sn, Sn-3Ag-0.5Cu, or the like.

Metal core printed circuit board 7 is mainly formed of metal having good heat conductivity. On this metal core printed circuit board 7, insulating layer 8 is formed. Insulating layer 8 may use, for example, glass fiber impregnated with epoxy resin. On insulating layer 8, pattern wiring 9 composed of copper is formed. Lead frame electrode 2 is fixed to pattern wiring 9 with solder 12.

Body 11 of the present exemplary embodiment, as described above, uses graphite having anisotropic heat conductivity. For body 11, for example, a composite material of graphite and aluminum, GC320 (from GELTEC Co., Ltd.: density: 2.17 [g/cm³]) may be used. The density of GC320 is about a quarter of the density of iron of 7.9 [g/cm³], thereby body 11 can be made lighter.

The heat conductivity of GC320 is 320 [Wm⁻¹K⁻¹] in a predetermined direction, and 172 [Wm⁻¹K⁻¹] in a direction perpendicular to the predetermined direction. In the present exemplary embodiment, the heat conductivity of 172 [Wm⁻¹K⁻¹] is the first heat conductivity, and the heat conductivity of 320 [Wm⁻¹K⁻¹] is the second heat conductivity.

Body 11 is configured in a manner such that the direction in heat conductivity is higher is parallel to main surface 11a (direction X₁ in FIG. 2 in which heat conductivity is higher). Main surface 11a is used as a heat dissipation surface.

Body 11 has bore 11 b formed therein, and metal core printed circuit board 7 is inserted into this bore 11 b by press fitting. That is, inner wall 11c of body 11 is brought into contact with side wall 7a of metal core printed circuit board 7. Inner wall 11 c is formed in a direction intersecting with direction X₁ in which heat conductivity is high. In the present exemplary embodiment, inner wall 11c is orthogonal to direction X₁ in which heat conductivity is high. In addition, heat transfer agent 13 is applied between side wall 7a and inner wall He. Heat transfer agent 13 that is applied may be, for example, thermally conductive grease, a thermally conductive adhesive, or the like. Heat transfer agent 13 may be applied between insulating layer 8 and metal core printed circuit board 7.

Next, in the lighting device configured as described above of the present exemplary embodiment, transfer of the heat generated by LED chip 1 will be described.

The heat generated by LED chip 1 is transferred to heat sink 6, pattern wiring 9, insulating layer 8 and heat transfer agent 13 in this order. This heat is further transferred from heat transfer agent 13 to metal core printed circuit board 7. The heat transferred to metal core printed circuit board 7 is dissipated from underside 7b of metal core printed circuit board 7 to the atmosphere, and conducted through metal core printed circuit board 7 in direction X. The heat conducted in direction X is transferred from side wall 7a of metal core printed circuit board 7 to heat transfer agent 13, and further transferred from heat transfer agent 13 to inner wall 11c of body 11. The heat transferred to body 11 is mainly conducted in direction X₁ in which heat conductivity is high. The heat is dissipated from main surface 11a to the atmosphere while being conducted in direction X₁ having the higher heat conductivity.

In the configuration of the present exemplary embodiment, the heat to be transferred from metal core printed circuit board 7 is transferred from inner wall 11c perpendicular to direction X₁ in which heat conductivity is high rather than from main surface 11 a of body 11. That is, because the heat is transferred toward direction X₁ in which heat conductivity is high, heat conductivity in the thickness direction (direction X) can be prevented from having any effect on heat conduction in body 11 in direction X.

Then, according to the configuration of the present exemplary embodiment, the entire thickness of body 11 can be effectively used to conduct the heat in direction X even if body 11 is configured so that the heat conductivity in the thickness direction of the graphite is low. Further, the configuration of the present exemplary embodiment allows the amount of heat conduction in direction X to be increased proportionally to the thickness of body 11.

Further, in the configuration of the present exemplary embodiment, because heat diffusion characteristics in the direction parallel to main surface 11a are higher compared to in the thickness direction, main surface 11a can be effectively used for heat dissipation.

In addition, in the present exemplary embodiment, there has been provided an example in which the composite material of graphite and aluminum is used for body 11. That is, an example has been provided in which body 11 uses the heat conduction member formed by combining a material having anisotropic heat conductivity and a material having isotropic heat conductivity. However, the invention is not limited to this. That is, for body 11, a composite material of graphite and resin having anisotropic heat conductivity may be used. In this case, a more lightweight device can be provided.

The present exemplary embodiment has shown an example of the lighting device having one LED chip implemented therein. It is assumed that the LED chip is, for example, a white LED formed by combining a blue LED and a fluorescent substance for conversion into visible light, excited by the blue LED as a light source. By using LEDs of blue, green and red, a full color backlight module can be provided.

### (Second Exemplary Embodiment)

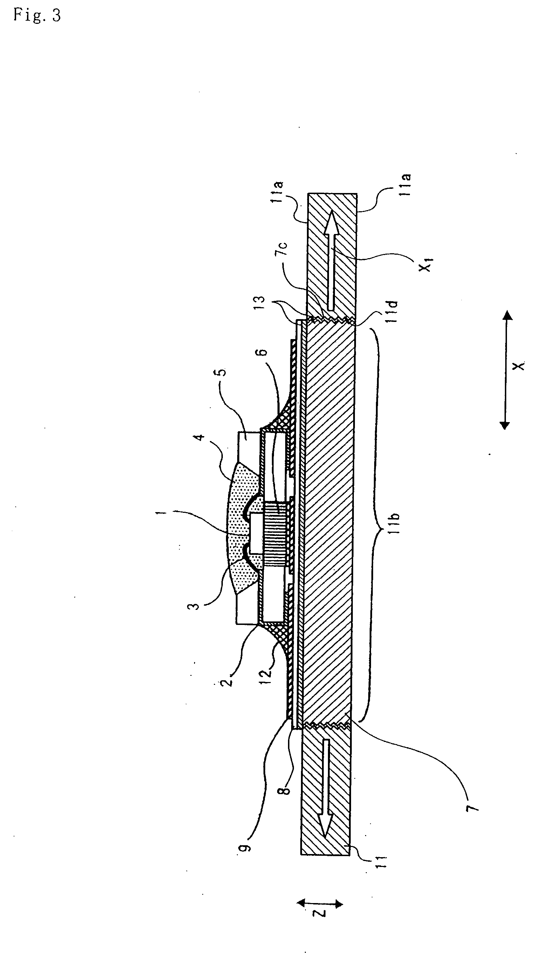

FIG. 3 is a schematic, side cross-section view of a lighting device of the present exemplary embodiment.

A basic configuration of the lighting device of the present exemplary embodiment is similar to that of the lighting device shown in the first exemplary embodiment. That is, body 11 is configured so that direction X₁ in which heat conductivity is high, similarly to the first exemplary embodiment, is set to be parallel to main surface 11a, but differs in that metal core printed circuit board 7 is threaded into bore 11 b rather than being inserted by press fitting. In addition, the other components having the same configuration are indicated by like symbols, and overlapped description will be omitted.

A side wall of metal core printed circuit board 7 is tapped to produce male thread 7c, and an inner wall of bore 11 b of body 11 is also tapped to produce female thread 11d. Then, metal core printed circuit board 7 is threaded into bore 11 b of body 11 and attached. In addition, it is preferable that a thread pitch of male thread 7c and female thread 11d be as small as possible. Because the thread pitch is made as small as possible, the heat to be transferred form metal core printed circuit board 7 can be transferred toward direction X₁ having the higher heat conductivity, similarly to the first exemplary embodiment from a macroscopic viewpoint.

Also, in the present exemplary embodiment, similarly to the first exemplary embodiment, the heat to be transferred from the metal core printed circuit board 7 is transferred from inner wall 11c rather than from main surface 11 a of body 11. Consequently, even when body 11 is so configured that heat conductivity in the thickness direction of graphite is low also in the present exemplary embodiment similarly to the first exemplary embodiment, the entire thickness of body 11 can be effectively used to conduct the heat in direction X.

Also, the configuration of the present exemplary embodiment, similarly to the first exemplary embodiment, can effectively utilize main surface 11a to dissipate heat because heat diffusion characteristics in the direction parallel to main surface 11 a is higher compared to in the thickness direction.

While preferred embodiments of the present invention have been described using specific terms, such description is for illustrative purposes only, and it is to be understood that changes and variations may be made without departing from the spirit or scope of the following claims.

## Claims

1. A lighting device, comprising:
a light emitting unit having a light emitting element installed on a board; and
a body having the light emitting unit mounted thereon, wherein
the body has a heat conduction member having anisotropic heat conductivity,
the heat conduction member has a heat transfer surface in thermal contact with the light emitting unit,
the anisotropy includes a first direction and a second direction in which heat conductivity in the second direction is higher than heat conductivity in the first direction, and
the heat conduction member is formed so that the heat transfer surface intersects with the second direction.

2. The lighting device according to claim 1, wherein
the heat conduction member is formed so that the heat transfer surface is orthogonal to the second direction.

3. The lighting device according to claim 1, wherein
the heat conduction member has a main surface functioning as a heat dissipation surface, formed in a direction intersecting with the heat transfer surface, and
the heat conduction member is so configured that the main surface and the second direction are parallel to each other.

4. The lighting device according to claim 1, wherein
in the heat conduction member, a bore is formed so that an inner wall thereof is the heat transfer surface, and
the board of the light emitting unit is inserted into the bore.

5. The lighting device according to claim 4, wherein
the board is inserted into the bore by press-fitting.

6. The lighting device according to claim 4, wherein
the board is threaded into the bore.

7. The lighting device according to claim 1, wherein
thermally conductive grease or a thermally conductive adhesive is applied between the board and the heat transfer surface.

8. The lighting device according to claim 1, wherein
the heat conduction member is graphite.

9. The lighting device according to claim 1, wherein
the light emitting element is an LED chip.
